(19) Europäisches Patentamt / European Patent Office / Office européen des brevets

(11) EP 2 267 090 B1

# (12) EUROPEAN PATENT SPECIFICATION

(45) Date of publication and mention of the grant of the patent:
**12.09.2018 Bulletin 2018/37**

(21) Application number: **09735160.5**

(22) Date of filing: **21.04.2009**

(51) Int Cl.:
***C09J 5/00*** (2006.01) ***C09J 7/22*** (2018.01)
***H01L 21/683*** (2006.01)

(86) International application number:
**PCT/KR2009/002082**

(87) International publication number:
**WO 2009/131363 (29.10.2009 Gazette 2009/44)**

## (54) PRESSURE-SENSITIVE ADHESIVE FILM AND BACK-GRINDING METHOD USING THE SAME

DRUCKEMPFINDLICHER KLEBEFILM UND RÜCKSEITENSCHLEIFVERFAHREN DAMIT

FILM ADHÉSIF ET PROCÉDÉ D'AMINCISSEMENT DE PLAQUETTE UTILISANT LEDIT FILM

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **21.04.2008 KR 20080036718**

(43) Date of publication of application:
**29.12.2010 Bulletin 2010/52**

(73) Proprietor: **LG Chem, Ltd.**
**Youngdungpo-gu**
**Seoul 150-721 (KR)**

(72) Inventors:
- **KIM, Se Ra**
  **Daejeon 305-816 (KR)**
- **BAEK, Yoon Jeong**
  **Daejeon 305-741 (KR)**
- **KIM, Jang Soon**
  **Daejeon 305-772 (KR)**
- **SON, Hyun Hee**
  **Cheongju-si**
  **Chungcheongbuk-do 361-765 (KR)**
- **HONG, Jong Wan**
  **Daejeon 305-340 (KR)**
- **PARK, Hyun Woo**
  **Chungju-si**
  **Chungcheongbuk-do 361-758 (KR)**

(74) Representative: **Cabinet Plasseraud**
**66, rue de la Chaussée d'Antin**
**75440 Paris Cedex 09 (FR)**

(56) References cited:
**EP-A1- 1 858 999**
**EP-A2- 0 798 355**
**EP-A2- 0 962 509**
**EP-A2- 0 999 250**
**WO-A2-2007/109326**
**JP-A- 2002 069 396**
**JP-A- 2004 256 595**
**JP-A- 2005 347 382**
**JP-A- 2006 013 452**
**JP-A- 2006 156 754**
**JP-A- 2006 335 860**
**JP-A- 2006 335 860**
**JP-A- 2007 045 965**
**JP-A- 2007 238 802**
**KR-A- 20050 118 302**
**US-A1- 2005 164 509**
**US-A1- 2005 244 631**

- **ROYLANCE D: "Stress Strain Curves", INTERNET CITATION, 23 August 2001 (2001-08-23), pages 1-14, XP003023088, Retrieved from the Internet: URL:http://www.web.archive.org/web/20050207150444/http://geomembrane.com/Tech/Papers/PVCMechanical.htm**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 267 090 B1

## Description

### Technical Field

The present invention relates to a pressure-sensitive adhesive film and a backgrinding method.

### Background Art

With the recent tendency towards miniaturization and weight-reduction of electronic products, there is an increasing demand for leadless, thin-film, and high-integration chip semiconductor packages. To meet the demand, a need for large-diameter thin-film wafers included in the semiconductor packages is also increasing.

In order to effectively cope with the tendency towards large diameter thin-film semiconductor wafers, it is important to precisely control a backgrinding process, which is a wafer grinding process, and a dicing process, which is a reorganizing process. To this end, high-performance techniques capable of controlling these processes are required. The backgrinding process is a process of mechanically or chemically polishing the surface of a wafer having a high-integration interconnection circuit to make the wafer thin. In this process, for example in the case of an 8-inch wafer, it is common to grind the wafer to about 200 $\mu$m to 400 $\mu$m, which is about half of the pre-process thickness. However, with the demand for thin-film wafers, it is currently necessary to grind a wafer to 200 $\mu$m or less, and thus a protective film is often used not only to protect the thin-film wafer during grinding but also as a reinforcement for handling the thin-film wafer. Moreover, as the diameter of the wafer increases, wafer damage such as wafer contamination and cracks frequently occur during the backgrinding process. In this regard, the role of a wafer processing protective film is regarded as important.

Korean Patent Registration No. 624293 discloses a pressure-sensitive adhesive film which can be used to process a back surface of an adherend having a large uneven surface shape by limiting the dynamic viscoelasticity (tanδ) of a base film in a particular temperature range. Korean Patent Publication No. 2006-47526 discloses a semiconductor wafer protecting pressure-sensitive adhesive film whose storage modulus is limited at a specific temperature in order to prevent damage of a thin-film semiconductor wafer.

However, even though the pressure-sensitive adhesive films suggested in the foregoing conventional techniques can prevent damage to the wafer during back surface grinding, their properties are significantly poor with regards to cutting of the wafer during the process. When the cutting property of the protective film is poor, a semiconductor processing process is discontinuously performed due to film cutting failure during the semiconductor processing process, which is performed in-line, resulting in degradation of processing efficiency.

### Disclosure

### Technical Problem

The present invention has been made upon consideration of the foregoing problems in the prior art, and an object thereof is to provide a pressure-sensitive adhesive film having excellent cuttability, adhesion properties, cushioning properties, peeling properties, water resistance and wettability to a wafer during semiconductor manufacturing processes, and a method of using the pressure-sensitive adhesive film.

### Technical Solution

In order to achieve the foregoing object, the present invention provides a pressure-sensitive adhesive film including:

a base film having a toughness of less than 2354 N.mm (240 Kgf·mm) at a temperature of 23°C; and
a pressure-sensitive adhesive layer formed on the base film.

In order to achieve the foregoing object, the present invention also provides a backgrinding method including:

a 1st step of adhering the pressure-sensitive adhesive film according to the present invention to a semiconductor wafer; and
a 2nd step of grinding the back surface of the semiconductor wafer to which the pressure-sensitive adhesive film is adhered.

## Advantageous Effects

In the present invention, a pressure-sensitive adhesive film is provided, which can remarkably raise the efficiency of production in semiconductor manufacturing processes such as wafer backgrinding, since it has superior cuttability and adhesion properties in the semiconductor manufacturing processes, and an excellent cushioning property. Moreover, the present invention also provides a pressure-sensitive adhesive film having superior peeling and re-peeling properties, that provides wettability to the wafer while providing excellent water resistance, and a backgrinding method using the pressure-sensitive adhesive film. According to the present invention, when the protective film is adhered to the wafer and cut according to the shape of the wafer, no foreign substances are introduced to the film and burr formation can be minimized due to a clear cutting plane. Therefore, according to the present invention, operational delays that may occur in semiconductor processing can be solved and burr formation in the film cutting plane can be minimized, thereby minimizing contamination and damage of the wafer caused by the introduction of water or other substances during a backgrinding process. Moreover, according to the present invention, the film can prevent the wafer from being bent with its excellent cushioning property, thus solving some problems in conventional semiconductor processing and improving the efficiency of continuous processing operations.

## Description of Drawings

FIG. 1 is one illustration of tensile curves; and
FIGs. 2 and 3 are cross-sectional views of a pressure-sensitive adhesive film according to an embodiment of the present invention.

<Explanation of Reference Numerals in Drawings>

10: Base Film
20: Pressure-Sensitive Adhesive Layer
30: Releasing film

## Best Mode

The present invention relates to a pressure-sensitive adhesive film including:

a base film having a toughness of less than 2354 N.mm (240 Kgf·mm) at a temperature of 23°C; and
a pressure-sensitive adhesive layer formed on the base film.

Hereinafter, a pressure-sensitive adhesive film according to the present invention will be described in detail.
The pressure-sensitive adhesive film includes a base film having an optimized toughness which is measured in a tensile test under specific conditions.
The term "tensile test" as used herein refers to a test for measuring the physical properties of a standardized specimen through a relationship between a force (force, stress) applied to the specimen and the elongation of the specimen when the specimen is pulled by the force applied at a predetermined speed. The results of the tensile test can be expressed with a tensile curve which shows the strain of the specimen with respect to the applied force. The tensile curve can be representatively classified into a *load-versus-elongation curve* (the left curve in FIG. 1) which is expressed by the relationship of elongation (mm) with respect to an applied force ($10^3$ N); and a *stress-versus-strain curve* (the right curve in FIG. 1) which is expressed by the relationship of engineering strain with respect to engineering stress.
The terms "engineering stress" and "engineering strain" as used above refer to normalized values of the applied force and the strain corresponding thereto, and can be expressed as follows:

[Equation 1]

$$\sigma = \frac{P}{A_o}$$

[Equation 2]

$$\epsilon = \frac{l - l_o}{l_o} = \frac{\Delta l}{l_o}$$

In Equations 1 and 2, σ represents engineering stress (MPa), P represents a force (N) applied to a specimen, $A_o$ represents the initial cross-sectional area ($mm^2$) of the specimen, ε represents engineering strain (mm/mm), $l_o$ represents the initial length (mm) of the specimen, and l represents the final length (mm) of the specimen after the tensile test.

The term "toughness" as used herein refers to a value measured by the tensile test, specifically, a value indicating the degree of hardness and softness of a material. The toughness may be calculated, for example, by integrating a force (or engineering stress)-elongation (or engineering strain) curve that is plotted until the specimen is destroyed.

The pressure-sensitive adhesive film may include a base film having a toughness of less than 2354 N.mm (240 Kgf·mm) or less, and preferably 2059 N.mm (210 Kgf·mm) or less. Also, in the present invention, the toughness may be measured at a temperature of 23°C, preferably at 20°C to 25°C, and more preferably about 15°C to 30°C.

The toughness of the base film may be measured, for example, by a method described below. Firstly, a specimen in the shape of a predetermined-size film is manufactured as a base film to be subject to a toughness measurement. The specimen may be in the shape of a film, and have, for example, a length of about 15 mm and a width of about 15 mm. The said sizes of the specimen such as length and width refer to the size of portions other than portions to be taped for fixation of the specimen.

After the specimen is manufactured under the foregoing conditions, the specimen is installed such that the lengthwise direction of the specimen is orthogonal to a machine (tensile tester) direction and a force is applied in the lengthwise direction at a tensile speed of about 180 mm/min to about 220 mm/min, and preferably about 200 mm/min. Then a graph of the force with respect to distance until the specimen is cut is expressed as a graph of elongation (X axis) and tensile strength (Y axis) by applying the width and thickness of the film (specimen). When the tensile curve is made in the foregoing manner, the tensile modulus may be measured from the initial slope of the curve, and the toughness may be measured by the area of the curve.

In the present invention, if the toughness is not less than 2354 N.mm (240 Kgf · mm), the film may be excessively hard and its cutting property may be degraded due to an increase in the elastic modulus of the base film. Moreover, if the toughness of the base film excessively increases, the cushioning property may be weakened and thus, for example, when the film is applied to the wafer backgrinding process, the stress-relaxing effect of the film may be deteriorated, causing a reduction in grinding precision or wafer damage.

In the present invention, a lower limit of the toughness of the base film is not specifically limited as long as it is within the above-mentioned range. However, if the toughness of the base film is too small, excessive softening of the film may occur, causing cracks or damage to the wafer when the film is wound around a roll or the wound film is released from the roll to be adhered to the wafer. Thus, in the present invention, the toughness of the base film may be adjusted properly in a range of 588 N.mm (60 Kgf · mm) or more.

The base film included in the pressure-sensitive adhesive film according to the present invention preferably has an elongation, which is measured by the tensile test, of less than 700%, but is preferably 650% or less, and is more preferably 600% or less. If the elongation is not less than 700%, cracks or damage may occur in the wafer during the wafer adhering process. In the present invention, a lower limit of the elongation is not specifically limited, and for example, it may be adjusted in a range of 20% or more.

The base film included in the pressure-sensitive adhesive film preferably has a storage modulus of $1\times10^7$ Pa to $1\times10^9$ Pa at a temperature of 20°C. If the storage modulus is less than $1\times10^7$ Pa, wafer cracks or damage may occur in the wafer adhering process. If the storage modulus is in excess of $1\times10^9$ Pa, the cutting and cushioning properties of the film and the grinding precision may be degraded or wafer damage may occur.

The structure of the base film included in the pressure-sensitive adhesive film is not specifically limited as long as it comprises a film having the foregoing properties. For example, the pressure-sensitive adhesive film may comprise a single layer of the base film having the foregoing properties, as shown in FIG. 2. Also, the base film may comprise two or more layers, and in this case, one or more layers of the multi-layered base film may meet the foregoing range,

or the entire multi-layered base film may have the physical properties in the foregoing range.

The base film used in the present invention is not specifically limited as long as it satisfies the properties in the foregoing range. In the present invention, a base film may be used, for example, which is composed of one or more selected from the group consisting of a polyolefin such as polyethylene, polypropylene, ethylene-vinyl acetate copolymer, ethylene-alkyl(meth)acrylate copolymer (wherein, alkyl may be an alkyl group of 1 to 4 carbon atoms), ethylene-$\alpha$-olefin copolymer, or propylene-$\alpha$-olefin copolymer; a polyester such as polyethyleneterephthalate or polybutyleneterephthalate; polyvinylchloride; polyester elastomer; and urethane polymer. In the present invention, a method of preparing the base film is not specifically limited, and for example, the base film may be prepared by (T die) extrusion, inflation, casting, or calendaring.

In the present invention, the thickness of the base film is not specifically limited and the base film may be formed to a general thickness. In one embodiment of the present invention, for example, the thickness of the base film may be controlled to be in a range of about 50 $\mu$m to 300 $\mu$m or about 100 $\mu$m to 200 $\mu$m, in order to obtain a base film having the toughness as described above.

In one embodiment of the present invention, surface treatments such as primer treatment or corona treatment may be performed on the base film to improve close adhesion to a pressure-sensitive adhesive layer, and a suitable color may be added for efficient semiconductor processing.

The pressure-sensitive adhesive film includes a pressure-sensitive adhesive layer 20 formed on a base film 10, as shown in FIG. 2.

The pressure-sensitive adhesive layer 20 is not specifically limited as long as it is low-contaminable with respect to the wafer surface and can prevent lifting of the pressure-sensitive adhesive film during wafer grinding. In the present invention, for example, a silicon pressure-sensitive adhesive, a synthetic rubber pressure-sensitive adhesive, a natural rubber pressure-sensitive adhesive, or an acrylic pressure-sensitive adhesive may be used as the pressure-sensitive adhesive layer 20.

If an acrylic pressure-sensitive adhesive is used as a pressure-sensitive adhesive formed on the base film, it may include a copolymer of 90 to 99.9 parts by weight of a (meth)acrylic acid ester monomer; and 0.1 to 10 parts by weight of a monomer containing a cross-linking functional group.

The (meth)acrylic acid ester monomer is not specifically limited, and for example, alkyl (meth)acrylate may be used. In this case, if an alkyl group included in the monomer becomes an excessively long chain, the cohesive strength of the pressure-sensitive adhesive is degraded and the glass transition temperature ($T_g$) or the pressure-sensitive adhesive property may become difficult to control. For this reason, it is desirable to use an alkyl (meth)acrylate having an alkyl group of 1 to 12 carbon atoms. Examples of such a monomer may include methyl (meth)acrylate, ethyl (meth)acrylate, n-propyl (meth)acrylate, isopropyl (meth)acrylate, n-butyl (meth)acrylate, t-butyl (meth)acrylate, sec-butyl (meth)acrylate, pentyl (meth)acrylate, 2-ethylhexyl (meth)acrylate, 2-ethylebutyl (meth)acrylate, n-octyl (meth)acrylate, isooctyl (meth)acrylate, isobornyl (meth)acrylate, isononyl (meth)acrylate, lauryl (meth)acrylate, or tetradecyl (meth)acrylate, and in the present invention, they can be used alone or in a mixture of two or more kinds thereof. If the acrylic pressure-sensitive adhesive resin includes the (meth)acrylic acid ester monomer, the content thereof is preferably 10 to 99.9 parts by weight. If the content is less than 10 parts by weight, the initial adhesive strength of the pressure-sensitive adhesive is likely to be degraded. If the content is in excess of 99.9 parts by weight, durability may be poor due to deterioration of the cohesive strength.

In one embodiment of the present invention, among the alkyl (meth)acrylate components, isobornyl (meth)acrylate may be included as an essential component. Isobornyl (meth)acrylate is a hard-type monomer having a low hydrophilic property. Thus, if isobornyl (meth)acrylate is included in the foregoing copolymer, the pressure-sensitive adhesive layer can have a high hydrophilic property while having high cross-linking density and low pressure-sensitive adhesive strength. In addition, if isobornyl (meth)acrylate is copolymerized with another copolymerizable monomer having a low glass transition temperature in the present invention, it is possible to obtain a pressure-sensitive adhesive having superior water resistance and wettability to the wafer and an excellent re-peeling property in the application as a protective film for a wafer.

The content of isobornyl (meth)acrylate in the pressure-sensitive adhesive layer is not specifically limited, and for example, isobornyl (meth)acrylate may be included at about 1 to 30 parts by weight, but preferably 5 to 25 parts by weight, with respect to 100 parts by weight of the entire monomer. If the content is less than 1 part by weight, the water resistance improving effect may be degraded. If the content is in excess of 30 parts by weight, smooth peeling may not be obtained or a stick-slip phenomenon may occur.

The monomer containing a cross-linking functional group that can be included in the acrylic polymer may adjust endurance reliability, pressure-sensitive adhesive strength, and cohesive strength by adding a cross-linking functional group, which can react with a multi-functional cross-linking agent to be described below, to the copolymer.

Examples of the monomer containing a cross-linking functional group that can be used may include a hydroxy group-containing monomer, a carboxyl-group containing monomer and a nitrogen group-containing monomer, without being limited thereto. Examples of the hydroxy group-containing monomer include 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 2-hydroxylethyleneglycol (meth)acrylate, or 2-hydroxyphrophyleneglycol (meth)acrylate. Examples of the carboxyl group-containing monomer include methacrylic acid, 2-(meth)acryloyloxy propyl acid, 4-(meth)acryloyloxy butyl acid, an acrylic acid dimer, itaconic acid, maleic acid, or maleic anhydride. Examples of the nitrogen-containing monomer include (meth)acryl amide, N-vinyl pyrrolidone, or N-vinyl caprolactam, without being limited thereto. In the present invention, they can be used alone or in a mixture of two or more kinds thereof.

The monomer containing a cross-linking functional group is preferably included in the aforementioned copolymer at 0.1 to 10 parts by weight. If the content is less than 0.1 parts by weight, the endurance reliability of the pressure-sensitive adhesive is likely to be degraded. If the content is in excess of 10 parts by weight, the pressure-sensitive adhesive property and/or the peeling strength may be deteriorated.

The acrylic copolymer according to the present invention may additionally include a copolymerizable monomer having a high glass transition temperature to add additional pressure-sensitive adhesive strength and cohesive strength. The copolymerizable monomer that can be included in the acrylic copolymer is not specifically limited as long as it performs the above-described function. For example, the copolymerizable monomer may be a compound expressed as follows:

[Formula 1]

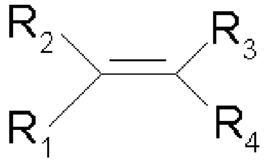

,

where $R_1$ to $R_3$ independently indicate hydrogen or alkyl, $R_4$ indicates cyano; penyl unsubstituted or substituted with alkyl; acetyloxy; or $COR_5$, where $R_5$ indicates amino or glycidyloxy either unsubstituted or substituted with alkyl or alkoxy alkyl.

In the definitions of $R_1$ to $R_5$, alkyl or alkoxy means an alkyl or alkoxy of 1 to 8 carbon atoms, preferably methyl, ethyl, methoxy, ethoxy, propoxy, or butoxy.

Detailed examples of the monomer expressed by Formula 1 may include, but are not limited to, one or two or more kinds of a (meth)acrylate such as methyl (meth)acrylate or ethyl (meth)acrylate; a nitrogen-containing monomer such as (meth)acrylonitrile, (meth)acryl amide, N-methyl (meth)acryl amide, or N-butoxy methyl (meth)acryl amide; a styrene monomer such as styrene or methyl styrene; glycidyl (meth)acrylate; or a carbonic acid vinyl ester such as vinyl acetate. When the co-monomer is included in the acrylic pressure-sensitive adhesive resin, its content is preferably less than 20 parts by weight. If the content is in excess of 20 parts by weight, the flexibility and/or peeling strength of a pressure-sensitive adhesive composition may be degraded.

The copolymer including the foregoing components preferably has a glass transition temperature of -50 to 15°C. If the glass transition temperature of the pressure-sensitive adhesive is less than -50°C, the peeling strength increases by a large amount according to the peeling speed, in which the peeling strength at a general peeling speed of about 1.0 m/min in a wafer processing process increases, causing wafer damage. If the glass transition temperature is in excess of 15°C, wettability to an adherend such as the wafer may be deteriorated or lifting may occur.

In the present invention, the copolymer preferably has a weight average molecular weight of 50,000 to 700,000. If the weight average molecular weight is less than 50,000, transfer-induced contamination may occur due to low cohesive strength. If the weight average molecular weight is in excess of 700,000, the pressure-sensitive adhesive property may be degraded.

In the present invention, a method of preparing the acrylic pressure-sensitive adhesive is not specifically limited, and the acrylic pressure-sensitive adhesive may be prepared by general polymerization such as solution polymerization, photo-polymerization, bulk polymerization, suspension polymerization, or emulsion polymerization. In the present invention, it is desirable to use solution polymerization, and solution polymerization is preferably performed at a polymerization temperature of 50°C to 140°C by adding an initiator in a state where monomers are evenly mixed. Examples of the initiator that can be used may include an azo-based polymerization initiator such as azobisisobutyronitrile or azobiscyclohexanecarbonitrile; and/or peroxide such as benzoyl peroxide and acetyl peroxide, and they can be used alone or in a mixture of two or more kinds thereof.

The pressure-sensitive adhesive according to the present invention may, in addition to the foregoing components, further include 0.1 to 10 parts by weight of a cross-linking agent with respect to 100 parts by weight of the copolymer. The cross-linking agent can adjust the pressure-sensitive adhesive property of the pressure-sensitive adhesive according to its amount used in the pressure-sensitive adhesive. The cross-linking agent may also improve the

cohesive strength of the pressure-sensitive adhesive by reacting with the cross-linking functional group included in the copolymer.

The cross-linking agent that can be used in the present invention is not specifically limited, and for example, a general cross-linking agent such as an isocyanate compound, an epoxy compound, an aziridine compound, or a metal chelate compound may be used.

The isocyanate cross-linking agent may use one or more kinds selected from a group consisting of toluene diisocyanate, xylenediisocyanate, diphenylmethanediisocyanate, hexamethylene diisocyanate, isophorone diisocyanate, tetramethylxylene diisocyanate, naphthalene diisocyanate, and their reactants with polyol like trimethylolpropane. The epoxy cross-linking agent may use one or more kinds selected from a group consisting of ethyleneglycol diglycidylether, triglycidylether, trimethylolpropane triglycidylether, N,N,N',N'-tetraglycidylethylenediamine, and glycerine diglycidylether. The aziridine cross-linking agent may use one or more kinds selected from a group consisting of N,N'-toluene-2,4-bis(1 -aziridinecarboxide), N,N'-diphenylmethane-4,4'-bis(1-aziridinecarbodixe), triethylenemelamine, bisisoprothaloyl-1-(2-methylaziridine), and tri-1-aziridinylphosphineoxide. The metal chelate cross-linking agent may use one or more kinds selected from a group consisting of compounds prepared by coordinating a multivalent metal such as Al, Fe, Zn, Sn, Ti, Sb, Mg, or V with acethylacetone or ethyl acetoacetate, without being limited thereto.

The cross-linking agent is preferably included at 0.1 to 10 parts by weight with respect to 100 parts by weight of the copolymer. If the content is less than 0.1 parts by weight, cohesion failure may occur under high temperature or high humidity conditions due to reduction of the cohesive strength of the pressure-sensitive adhesive. If the content is in excess of 10 parts by weight, endurance reliability may be deteriorated due to inter-layer peeling or lifting or compatibility or flexibility may be degraded.

In a range that does not have an influence upon the effect of the present invention, the pressure-sensitive adhesive according to the present invention further includes one or more additives selected from a group consisting of a tackifier resin, low-molecular weight epoxy resins, a curing agent, an ultraviolet (UV) stabilizer, antioxidants, a coloring agent, a reinforcing agent, an antifoaming agent, a surfactant, an antifoaming agent, a foaming agent, an organic salt, a thickening agent, and an antistatic agent.

In the present invention, a method of forming the pressure-sensitive adhesive layer on the base film is not specifically limited. For example, in the present invention, the method may include applying a coating liquid including the foregoing components directly to the surface of the base film by means of a bar coater, a knife coater, a roll coater, a spray coater, a gravia coater, a curtain coater, a comma coater and/or a lip coater and then drying it, or applying the pressure-sensitive adhesive to the thin-film base surface, drying it, transferring the pressure-sensitive adhesive layer formed on the thin-film base surface to the base surface, and then aging it.

In the present invention, it is desirable to adjust the cross-linking structure of the pressure-sensitive adhesive layer through proper drying and aging processes at the pressure-sensitive adhesive formation stage. By adjusting the cross-linking structure, it is possible to obtain a pressure-sensitive adhesive layer having elasticity and strong cohesion, thus improving the pressure-sensitive adhesive properties, such as endurance reliability, and the cutting property of the pressure-sensitive adhesive film. More specifically, the pressure-sensitive adhesive layer of the pressure-sensitive adhesive film preferably has a cross-linking density of 80 to 99%. If the cross-linking density of the pressure-sensitive adhesive layer is less than 80%, the cohesive strength of the pressure-sensitive adhesive layer is degraded and the pressure-sensitive adhesive component is transferred to an adherend such as the water, causing residues. If the cross-linking density is in excess of 99%, the peeling strength is reduced, resulting in immersion due to water spray during wafer processing.

The thickness of the pressure-sensitive adhesive layer of the pressure-sensitive adhesive film according to the present invention is preferably 0.5 to 50$\mu$m, and more preferably 1 to 30$\mu$m. If the thickness is out of this range, it is difficult to obtain a uniform pressure-sensitive adhesive layer, making the physical property of the film non-uniform.

In the pressure-sensitive adhesive film according to the present invention, to prevent foreign substances from entering the pressure-sensitive adhesive layer, a releasing film may be formed on the pressure-sensitive adhesive layer. FIG. 3 is a cross-sectional view showing a pressure-sensitive adhesive film according to an embodiment of the present invention, in which the pressure-sensitive adhesive layer 20 is formed on a side of the base film 10 and a releasing film 30 is formed on the pressure-sensitive adhesive layer 20. The releasing film is not specifically limited, and for example, a film obtained by release-treating one side or both sides of a polyethyleneterephthalate (PET) film or an olefin film with a silicon or alkyd releasing agent may be used. The thickness of the releasing film is set properly according to its usage without being specifically limited, and may be selected in a range of 10 to 70$\mu$m.

The pressure-sensitive adhesive film according to the present invention may be used as a semiconductor processing film such as a protective film during semiconductor wafer back surface grinding. By using a base film satisfying the distinctive physical properties, the pressure-sensitive adhesive film according to the present invention exhibits superior cutting and adhesion properties, and buffering and cushioning properties, thereby improving the efficiency of product mass production in a process such as wafer back surface grinding.

In other words, the present invention relates to a backgrinding method including:

a 1st step of adhering the pressure-sensitive adhesive film according to the present invention to a semiconductor wafer; and

a 2nd step of grinding a back surface of the semiconductor wafer to which the pressure-sensitive adhesive film is adhered.

The backgrinding method is characterized by using the pressure-sensitive adhesive film according to the present invention as a wafer processing protective film, and other detailed processing conditions are not specifically limited. For example, in the present invention, the backgrinding process may be performed after adhering the pressure-sensitive adhesive film to the wafer by means of a press or hot roll laminate method and fixing it to a grinding tool such as a grinder. As described above, the pressure-sensitive adhesive film according to the present invention can be effectively applied to the backgrinding process with its superior wettability to the wafer and excellent peeling and water resistance properties. In the grinding method according to the present invention, general semiconductor packaging processes such as wafer dicing, die-bonding, wire-bonding and molding can be performed continuously from the backgrinding process, and detailed conditions are not specifically limited.

## Mode for invention

Hereinafter, the present invention will be described in more detail with reference to examples according to the present invention and comparative examples which do not accord to the present invention. However, the scope of the present invention is not limited by the examples described below.

### Example 1

A monomer mixture (100 parts by weight) comprising isobornyl acrylate, methyl acrylate, ethyl acrylate, n-butyl acrylate and 2-hydroxyethyl acrylate was prepared such that 5 parts by weight of isobornyl acrylate (IBOA) were contained in the mixture, and the glass transition temperature of the resin prepared from the mixture was -25°C. Then, the monomer mixture was polymerized to prepare an acrylic pressure-sensitive adhesive resin having a solid content of 45 weight%. Next, an isocyanate cross-linking agent was added to the prepared pressure-sensitive adhesive resin in an amount of 2 parts by weight, relative to 100 parts by weight of the pressure-sensitive adhesive resin. The resultant was applied to an ethylene-acetic acid vinyl copolymer film (EVA) having a toughness of 1344 N.mm (137 Kgf · mm), a storage modulus of $5\times10^7$ Pa at 20°C, an elongation of 434%, a tensile strength of 1363 $N/cm^2$ (139 $Kgf/cm^2$), and then dried, thus preparing a pressure-sensitive adhesive film. The toughness, storage modulus, elongation, and tensile strength of the base film were evaluated in the following manner.

### (1) Measurement of toughness, elongation, and tensile strength

The base film was cut to a size of 15 mm in a machine direction of a measuring machine (XP plus, TA(manufacturer)) and 35 mm in a direction orthogonal to the machine direction, thereby preparing a specimen. Then, 10mm of the specimen was taped at the top and the bottom portion in the lengthwise direction (in the direction orthogonal to the machine direction). The taped top portion and the bottom portion (10 mm, respectively) of the specimen were fixed to the measuring machine. Then, by applying a force at a tensile speed of 200 mm/min, a graph of the force (Y axis) with respect to the distance (X axis) measured until the specimen was cut was plotted. Then, by applying the width and the thickness of the specimen, the plotted graph was expressed as a graph of elongation (X axis) and tensile strength (Y axis). After that, the tensile modulus and the toughness of the specimen were calculated from an initial slope and the area of the curve, respectively. Also, by applying 1mm notches with respect to the central portion in the lengthwise direction of the specimen with application of the force in the above manner, the toughness of the specimen was compared.

### (2) Measurement of storage modulus

A specimen was prepared by cutting the film to a size of 30 mm in a machine direction of a measuring machine and 5 mm in a direction orthogonal to the machine direction. The storage modulus of the prepared specimen was measured by using the measuring machine (dynamic viscoelasticity measuring device, Q800, TA(manufacturer)) at a frequency of 1 Hz while raising the temperature at a rate of 3 °C /min between -10°C and 100°C.

### Examples 2 to 4 and Comparative Examples 1 to 3

The type and physical properties of the base film were changed as shown in Table 1, but other than these changes the pressure-sensitive adhesive films were manufactured in the same manner as in Example 1.

[Table 1]

| | Examples | | | | Comparative Examples | | |
|---|---|---|---|---|---|---|---|
| | 1 | 2 | 3 | 4 | 1 | 2 | 3 |
| **Type of Film** | EVA | EVA | PVC | PE | EVA | EVA | PBT |
| **Toughness (no notch)** | 1344 N.mm (137 Kgf · mm) | 1128 N.mm (115 Kgf · mm) | 2089 N.mm (213 Kgf · mm) | 1883 N.mm (192 Kgf · mm) | 2756 N.mm (281 Kgf · mm) | 4256 N.mm (434 Kgf · mm) | 6727 N.mm (686 Kgf · mm) |
| **Storage modulus (Pa)(20°C)** | $5\times10^7$ | $6\times10^7$ | $8\times10^7$ | $3\times10^8$ | $8\times10^7$ | $9\times10^7$ | $5\times10^8$ |
| **Elongation (%)** | 434 | 376 | 435 | 543 | 968 | 845 | 1161 |
| **Tensile strength ($Kgf/cm^2$)** | 139 | 103 | 328 | 146 | 160 | 282 | 429 |
| **EVA: ethylene-acetic acid vinyl copolymer film<br>PVC: polyvinyl chloride film<br>PE: polyethylene film<br>PBT: polybutylene terephthalate film** | | | | | | | |

By using the prepared pressure-sensitive adhesive films of the Examples and Comparative Examples, the physical properties were evaluated in the manner descried below.

**1. Cuttability**

Pressure-sensitive adhesive films (protective films) prepared in the Examples and Comparative Examples were adhered to an 8-inch silicon (Si) wafer using a wafer mounter and were cut according to the wafer shape by using an expender (HS-1810, Hugle electronics Inc). Next, the height of a stage was set to 3 and the cutting planes of the pressure-sensitive adhesive films were observed. More specifically, the cutting start portion and central portion were observed with an optical microscope to obtain the degree of burr formation and any area torn by cutting for comparison of the cutting property based on criterion described below.

○: When the cutting start portion of the film was observed X50, the rate of an area formed by a tear with respect to the entire film area seen in an area portion at 640×480 resolution is less than 3%.
Δ : When the cutting start portion of the film was observed X50, the rate of an area formed by a tear with respect to the entire film area seen in an area portion at 640×480 resolution is 4 to 7%.
×: When the cutting start portion of the film was observed X50, the rate of an area formed by a tear with respect to the entire film area seen in an area portion at 640×480 resolution is 8% or more.

**2. Adhesion Property of Protective Film**

The pressure-sensitive adhesive films were adhered to the 8-inch silicon wafer using the wafer mounter (DS Precision Inc. DYWMDS-8') and the surface of the wafer was observed to calculate a portion where laminar bubbles were generated, after which an evaluation was made as o for 3 bubbles or less, Δ for 4 to 7 bubbles, and × for 8 bubbles or more.

**3. Wafer Grinding Property**

After the pressure-sensitive adhesive films were adhered to the 8-inch silicon wafer using the wafer mounter, the films were cut according to the wafer shape by the expender and then the amount of wafer damage and cracks was evaluated by using a back surface grinder (SVG-502MKII8). More specifically, grinding was performed 5 times and evaluation was made as ○ for 0 wafer cracks, Δ for 1 wafer crack, and × for 2 wafer cracks or more.

Results of measurement performed in the above manner are shown in Table 2.

[Table 2]

| | Examples | | | | Comparative Examples | | |
|---|---|---|---|---|---|---|---|
| | 1 | 2 | 3 | 4 | 1 | 2 | 3 |
| Cutting Property | ○ | ○ | ○ | ○ | Δ | × | × |
| Protective Film Adherence Property | ○ | ○ | ○ | ○ | ○ | Δ | × |
| Wafer Grinding Property | ○ | ○ | ○ | ○ | ○ | Δ | × |

As can bee seen from the results of Table 2, the Examples according to the present invention show excellent results in terms of all of the evaluated properties, specifically the cutting property, the adherence property, and the grinding property, whereas the Comparative Examples show poor physical properties.

In particular, Comparative Example 2, having excessively high toughness of the base film, shows a very poor result in terms of the cutting property, and Comparative Example 3, having excessively high elongation and toughness, shows poor results in terms of the cutting property, the adherence property, and the grinding property.

## Claims

1. A pressure-sensitive adhesive film comprising: a base film having a toughness of less than 2354 N.mm (240 Kgf·mm) at a temperature of 23°C; and
a pressure-sensitive adhesive layer formed on the base film,
wherein the base film has an elongation of less than 700%,
wherein the base film is a polyolefin film, a polyester film, a polyvinylchloride, a polyester elastomer or a urethane film,
wherein the pressure-sensitive adhesive layer comprises a silicon pressure-sensitive adhesive, a synthetic rubber pressure-sensitive adhesive, a natural rubber pressure-sensitive adhesive, or an acrylic pressure-sensitive adhesive,
wherein, to measure the toughness and elongation, the base film is cut to a size of 15 mm in a machine direction of a measuring machine (XP plus, TA(manufacturer)) and 35 mm in a direction orthogonal to the machine direction thereby preparing a specimen, then 10 mm of the specimen is taped at the top and the bottom portion in the lengthwise direction (in the direction orthogonal to the machine direction), the taped top portion and the bottom portion (10 mm, respectively) of the specimen are fixed to the measuring machine, then by applying a force at a tensile speed of 200 mm/min, a graph of the force (Y axis, N) with respect to the distance (X axis, mm) measured until the specimen is cut is plotted, then by applying the width and the thickness of the specimen, the plotted graph is expressed as a graph of elongation (X axis) and tensile strength (Y axis), the toughness of the specimen is calculated from the area of the graph of the force (Y axis, N) with respect to the distance (X axis, mm).

2. The pressure-sensitive adhesive film of claim 1, wherein the base film has a toughness of less than 2354 N.mm (240 Kgf·mm) at a temperature of 20°C to 25°C.

3. The pressure-sensitive adhesive film of claim 1, wherein the base film has a toughness of 2059 N.mm (210 Kgf·mm) or less.

4. The pressure-sensitive adhesive film of claim 1, wherein the base film has a storage modulus of $1 \times 10^7$ Pa to $1 \times 10^9$ Pa at a temperature of 20 °C.

5. The pressure-sensitive adhesive film of claim 1, wherein the base film has a thickness of 50 $\mu$m to 300 $\mu$m.

6. The pressure-sensitive adhesive film of claim 1, wherein the acrylic pressure-sensitive adhesive comprises a copolymer of monomers containing 90 to 99.9 parts by weight of a (meth)acrylic acid ester monomer; and 0.1 to 10 parts by weight of a monomer containing a cross-linking functional group.

7. The pressure-sensitive adhesive film of claim 6, wherein the (meth)acrylic acid ester monomer comprises isobornyl (meth)acrylate.

**8.** The pressure-sensitive adhesive film of claim 6, wherein the copolymer has a glass transition temperature of -50 to 15°C.

**9.** The pressure-sensitive adhesive film of claim 6, wherein the copolymer has a weight average molecular weight of 50,000 to 700,000.

**10.** The pressure-sensitive adhesive film of claim 6, wherein the pressure-sensitive adhesive further comprises 0.1 to 10 parts by weight of a cross-linking agent, relative to 100 parts by weight of the copolymer.

**11.** The pressure-sensitive adhesive film of claim 1, wherein the pressure-sensitive adhesive layer has a thickness of 0.5 $\mu$m to 50 $\mu$m.

**12.** The pressure-sensitive adhesive film of claim 1, further comprising a releasing film formed on the pressure-sensitive adhesive layer.

**13.** A backgrinding method comprising:

a 1$^{st}$ step of adhering the pressure-sensitive adhesive film of claim 1 to a semiconductor wafer; and
a 2$^{nd}$ step of grinding a back surface of the semiconductor wafer to which the pressure-sensitive adhesive film is adhered.

## Patentansprüche

**1.** Haftklebefolie, umfassend: eine Basisfolie, die eine Zähigkeit von weniger als 2354 N.mm (240 Kgf · mm) bei einer Temperatur von 23 °C aufweist; und
eine Haftklebeschicht, die auf der Basisfolie gebildet ist,
wobei die Basisfolie eine Dehnung von weniger als 700 % aufweist,
wobei die Basisfolie eine Polyolefinfolie, eine Polyesterfolie, ein Polyvinylchlorid, ein Polyesterelastomer oder eine Urethanfolie ist,
wobei die Haftklebeschicht einen Silikonhaftklebstoff, einen synthetischen Kautschukhaftklebstoff, einen natürlichen Kautschukhaftklebstoff oder einen Acrylhaftklebstoff umfasst,
wobei die Basisfolie, um die Zähigkeit und die Dehnung zu messen, auf eine Größe von 15 mm in eine Maschinenrichtung einer Messmaschine (XP plus, TA (Hersteller)) und 35 mm in eine Richtung orthogonal zu der Maschinenrichtung geschnitten wird, wodurch eine Probe hergestellt wird, dann wird 10 mm der Probe am oberen und am unteren Teil in der Längsrichtung (in der Richtung orthogonal zu der Maschinenrichtung) abgeklebt, der abgeklebte obere Teil und der untere Teil (jeweils 10 mm) der Probe werden an der Messmaschine fixiert, dann wird durch Anwenden einer Kraft bei einer Zuggeschwindigkeit von 200 mm/min ein Graph der Kraft (Y-Achse, N) in Bezug auf den Abstand (X-Achse, mm), gemessen bis die Probe abgetrennt wird, aufgezeichnet, dann wird der aufgezeichnete Graph durch Anwenden der Breite und der Dicke der Probe als ein Graph von Dehnung (X-Achse) und Zugfestigkeit (Y-Achse) ausgedrückt, und die Zähigkeit der Probe wird aus der Fläche des Graphs der Kraft (Y-Achse, N) in Bezug auf den Abstand (X-Achse, mm) berechnet.

**2.** Haftklebefolie nach Anspruch 1, wobei die Basisfolie eine Zähigkeit von weniger als 2354 N.mm (240 Kgf · mm) bei einer Temperatur von 20 °C bis 25 °C aufweist.

**3.** Haftklebefolie nach Anspruch 1, wobei die Basisfolie eine Zähigkeit von 2059 N.mm (210 Kgf · mm) oder weniger aufweist.

**4.** Haftklebefolie nach Anspruch 1, wobei die Basisfolie ein Speichermodul von $1 \times 10^7$ Pa bis $1 \times 10^9$ Pa bei einer Temperatur von 20 °C aufweist.

**5.** Haftklebefolie nach Anspruch 1, wobei die Basisfolie eine Dicke von 50 $\mu$m bis 300 $\mu$m aufweist.

**6.** Haftklebefolie nach Anspruch 1, wobei der Acrylhaftklebstoff ein Copolymer von Monomeren, enthaltend 90 bis 99,9 Gewichtsteile eines (Meth)acrylsäureestermonomers; und 0,1 bis 10 Gewichtsteile eines Monomers, das eine vernetzende funktionelle Gruppe enthält, umfasst.

7. Haftklebefolie nach Anspruch 6, wobei das (Meth)acrylsäureestermonomer Isobornyl(meth)acrylat umfasst.

8. Haftklebefolie nach Anspruch 6, wobei das Copolymer eine Glasübergangstemperatur von -50 bis 15 °C aufweist.

9. Haftklebefolie nach Anspruch 6, wobei das Copolymer ein gewichtsmittleres Molekulargewicht von 50.000 bis 700.000 aufweist.

10. Haftklebefolie nach Anspruch 6, wobei der Haftklebstoff ferner 0,1 bis 10 Gewichtsteile eines Vernetzungsmittels, bezogen auf 100 Gewichtsteile des Copolymers, umfasst.

11. Haftklebefolie nach Anspruch 1, wobei die Haftklebeschicht eine Dicke von 0,5 μm bis 50 μm aufweist.

12. Haftklebefolie nach Anspruch 1, ferner umfassend eine Trennfolie, die auf der Haftklebeschicht gebildet ist.

13. Hinterseiten-Schleifverfahren, umfassend:

einen ersten Schritt eines Anklebens der Haftklebefolie nach Anspruch 1 an einen Halbleiterwafer; und
einen zweiten Schritt eines Schleifens einer hinteren Oberfläche des Halbleiterwafers, an den die Haftklebefolie angeklebt ist.

## Revendications

1. Film adhésif sensible à la pression comprenant : un film de base ayant une ténacité inférieure à 2 354 N.mm (240 Kgf.mm) à une température de 23 °C ; et
une couche adhésive sensible à la pression formée sur le film de base,
dans lequel le film de base a un allongement inférieur à 700 %,
dans lequel le film de base est un film de polyoléfine, un film de polyester, un chlorure de polyvinyle, un élastomère de polyester ou un film d'uréthane,
dans lequel la couche adhésive sensible à la pression comprend un adhésif sensible à la pression à base de silicium, un adhésif sensible à la pression à base de caoutchouc synthétique, un adhésif sensible à la pression à base de caoutchouc naturel, ou un adhésif sensible à la pression à base d'acrylique,
dans lequel, pour mesurer la ténacité et l'allongement, le film de base est coupé à une taille de 15 mm dans un sens machine d'une machine de mesure (XP plus, TA (fabricant)) et 35 mm dans un sens orthogonal au sens machine permettant ainsi de préparer un échantillon, puis 10 mm de l'échantillon sont percés au niveau de la partie supérieure et de la partie inférieure dans le sens de la longueur (dans le sens orthogonal au sens machine), la partie supérieure percée et la partie inférieure (10 mm, respectivement) de l'échantillon sont fixées à la machine de mesure, puis par application d'une force à une vitesse de traction de 200 mm/min, un graphique de la force (axe des Y, N) relativement à la distance (axe des X, mm) mesurée jusqu'à ce que l'échantillon soit coupé est tracé, puis par application de la largeur et de l'épaisseur de l'échantillon, le graphique tracé est exprimé comme un graphique d'allongement (axe des X) et de résistance à la traction (axe des Y), la ténacité de l'échantillon est calculée à partir de la surface du graphique de la force (axe des Y, N) relativement à la distance (axe des X, mm).

2. Film adhésif sensible à la pression selon la revendication 1, dans lequel le film de base a une ténacité inférieure à 2 354 N.mm (240 Kgf.mm) à une température de 20 °C à 25 °C.

3. Film adhésif sensible à la pression selon la revendication 1, dans lequel le film de base a une ténacité inférieure à 2 059 N.mm (210 Kgf.mm) ou moins.

4. Film adhésif sensible à la pression selon la revendication 1, dans lequel le film de base a un module de conservation de 1 x $10^7$ Pa à 1 x $10^9$ Pa à une température de 20 °C.

5. Film adhésif sensible à la pression selon la revendication 1, dans lequel le film de base a une épaisseur de 50 μm à 300 μm.

6. Film adhésif sensible à la pression selon la revendication 1, dans lequel l'adhésif sensible à la pression à base d'acrylique comprend un copolymère de monomères contenant de 90 à 99,9 parties en poids d'un monomère d'ester de l'acide (méth)acrylique ; et de 0,1 à 10 parties en poids d'un monomère contenant un groupe fonctionnel de

réticulation.

7. Film adhésif sensible à la pression selon la revendication 6, dans lequel le monomère d'ester de l'acide (méth)acrylique comprend un (méth)acrylate d'isobornyle.

8. Film adhésif sensible à la pression selon la revendication 6, dans lequel le copolymère a une température de transition vitreuse de -50 à 15 °C.

9. Film adhésif sensible à la pression selon la revendication 6, dans lequel le copolymère a une masse moléculaire moyenne en poids de 50 000 à 700 000.

10. Film adhésif sensible à la pression selon la revendication 6, dans lequel l'adhésif sensible à la pression comprend en outre 0,1 à 10 parties en poids d'un agent de réticulation, relativement à 100 parties en poids du copolymère.

11. Film adhésif sensible à la pression selon la revendication 1, dans lequel la couche adhésive sensible à la pression a une épaisseur de 0,5 $\mu$m à 50 $\mu$m.

12. Film adhésif sensible à la pression selon la revendication 1, comprenant en outre un film démoulant formé sur la couche adhésive sensible à la pression.

13. Procédé d'amincissement comprenant :

une première étape d'adhérence du film adhésif sensible à la pression selon la revendication 1 à une plaquette semi-conductrice ; et
une seconde étape d'amincissement d'une surface arrière de la plaquette semi-conductrice à laquelle le film adhésif sensible à la pression est collé.

FIG. 1

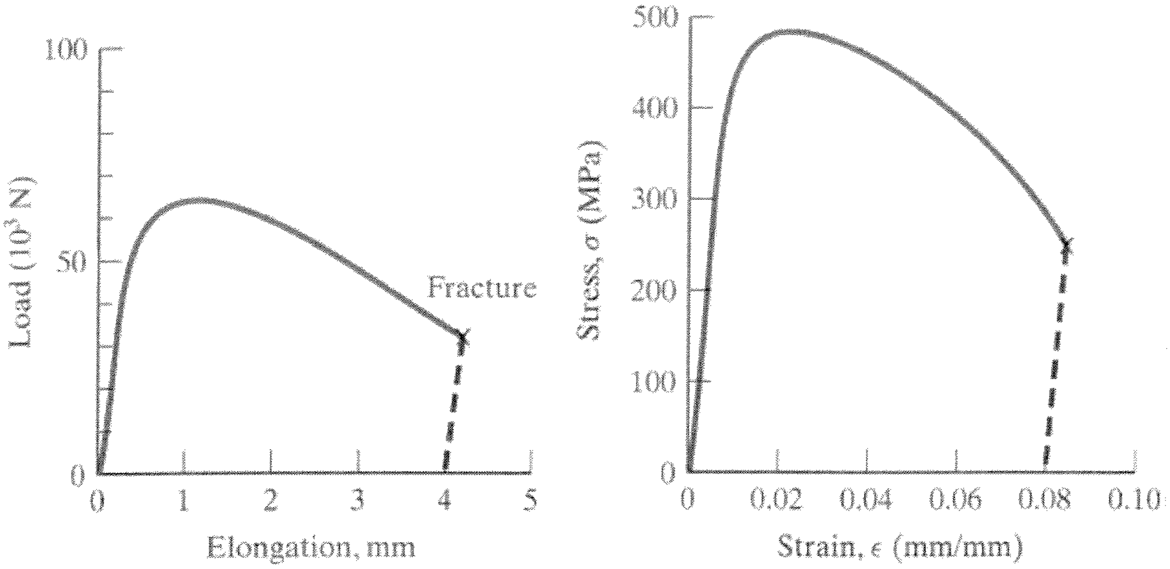


FIG. 2

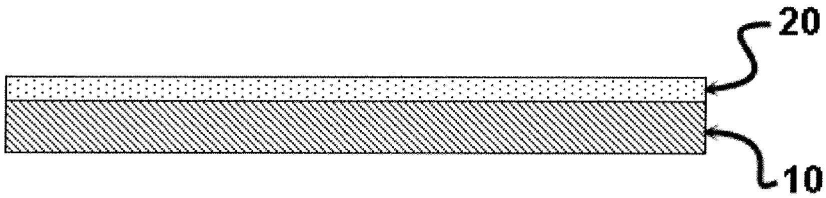


FIG. 3

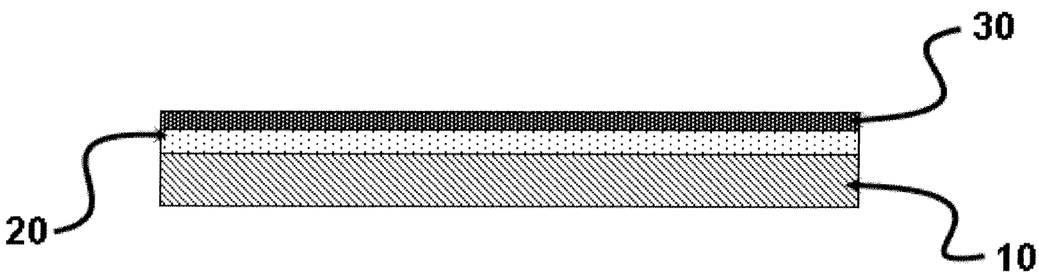

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 624293
- KR 200647526